# EUROPÄISCHE PATENTSCHRIFT

(11) **EP 2 414 132 B1**
(45) Veröffentlichungstag und Bekanntmachung des Hinweises auf die Patenterteilung: **22.03.2017**
(21) Anmeldenummer: 10710351.7
(22) Anmeldetag: 26.03.2010
(51) Int. Cl.: B23K 26/06, B23K 26/36, B23K 26/40, B28D 5/00, C03B 33/02, C03B 33/09, H01L 21/78

(54) **BAUTEIL MIT EINER ÜBERLAPPENDENDEN LASERSPUR; VERFAHREN ZUR HERSTELLUNG EINES SOLCHEN BAUTEILS**
COMPONENT HAVING AN OVERLAPPING LASER TRACK; METHOD FOR PRODUCING SUCH A COMPONENT
COMPOSANT COMPORTANT UN SILLON LASER EN CHEVAUCHEMENT, ET PROCÉDÉ DE FABRICATION D'UN TEL COMPOSANT

(30) Priorität: 31.03.2009 DE 102009015087
(43) Veröffentlichungstag der Anmeldung: 08.02.2012
(73) Patentinhaber: CeramTec GmbH, 73207 Plochingen (DE)
(72) Erfinder: REISS, Kunibert, 95701 Pechbrunn (DE); KARL, Thomas, 95632 Wunsiedel (DE); KLUGE, Claus Peter, 95195 Röslau (DE)
(74) Vertreter: Scherzberg, Andreas Hans
(86) Internationale Anmeldenummer: PCT/EP2010/053972
(87) Internationale Veröffentlichungsnummer: WO 2010/112412

(56) Entgegenhaltungen:
- WO-A1-2009/060048
- DE-A1-102007 014 433
- JP-A- 2008 198 905
- US-A1- 2005 155 954
- US-A1- 2005 263 854
- US-A1- 2006 255 022
- US-A1- 2007 090 100

## Beschreibung

Die Erfindung beschreibt ein Bauteil gemäß dem Oberbegriff des Anspruchs 1 (siehe, z.B., US 2005/155954 A1). Diese Erfindung betrifft auch ein Verfahren zum Herstellen eines solchen Bauteils, siehe Anspruch 11.

Zur Herstellung von Sollbruchstellen in keramischen Bauteilen wird u. a. das Laserverfahren eingesetzt. Die durch Lasern vorbereiteten Bauteile werden zur kostengünstigen Herstellung von Einzelbauteilen im Mehrfachnutzen bearbeitet (prozessiert) und anschließend zu Einzelbauteilen vereinzelt (Einzelnutzen). Hierzu werden in definierten Abständen Einschüsse, ähnlich einer Perforation, in die Oberfläche des Bauteils eingebracht. Diese eingebrachten Störstellen wirken als Bruchinitiierungslinie und vermindern die Bruchkraft ortselektiv und ermöglichen einen vorgegebenen Bruchverlauf.

Ein derartiges Verfahren wird verwendet um mechanische Schneid- und/oder Prägeverfahren zu ersetzen und hat sich auch in der Ritztechnik etabliert. Dabei werden Sacklöcher linienförmig aneinander gereiht und dienen bei Bauteilen aus spröden Materialien wie Metallguss oder Keramiken als Sollbruchstellen bzw. Bruchinitiierungslinien. Dieses Verfahren wird auch zum Vereinzeln von Keramikplatten verwendet.

Standardmäßig werden beim Laserritzen Einschüsse in definierten Abstand in das Material eingebracht.

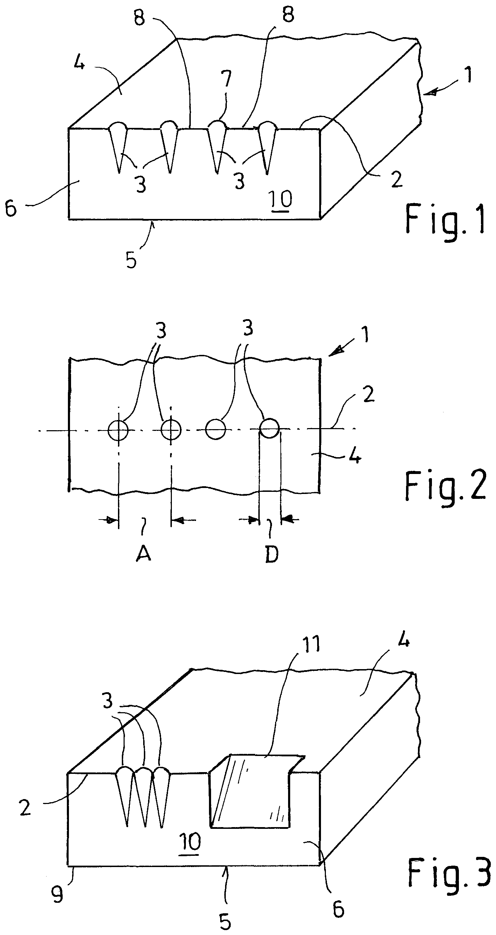

Bei diesem Verfahren kann es durch die Perforation bedingt zu Abweichungen von den Sollbruchstellen kommen. Unter Umständen sind auch nicht symmetrische Bruchverläufe zu beobachten. Ein Teil der Seitenflächen nach dem Vereinzeln weist eine Abfolge von Halbkreisen und Stegen (siehe Figur 1) auf und sind im Vergleich zu einer mechanisch eingebrachten nahezu glatten Kerboberfläche, als makroskopisch rauh zu bezeichnen. Besonderes Augenmerk liegt hier auf einzelnen aus der Sollbruchlinie erhabenen Stegen.

Als Laserritzlinie oder Laserspur wird nachfolgend eine gedachte Linie verstanden, welche durch den Mittelpunkt aller Einschüsse führt.

Der Erfindung liegt die Aufgabe zugrunde, ein Bauteil mit einer Laserspur anzugeben, bei dem sichergestellt ist, dass beim Vereinzeln der Bruch immer entlang der Laserspur verläuft, Brüche abweichend von der Laserspur vermieden werden und die Bruchkanten nach dem Brechen gleichmäßig geformt sind und keine Ausfransungen aufweisen.

Erfindungsgemäß wird diese Aufgabe durch die Merkmale des Anspruchs 1 gelöst.

Dadurch, dass der Abstand A zwischen zwei benachbarten Lasereinschüssen kleiner oder gleich dem Durchmesser D dieser Lasereinschüsse ist, jeweils gemessen an der Oberfläche des Bauteils, verläuft der Bruch immer entlang der Laserspur, Brüche abweichend von der Laserspur werden vermieden und die Bruchkanten sind nach dem Brechen gleichmäßig geformt und weisen keine Ausfransungen auf.

Der Lasereinschuss ist ein Punkt, um diesen herum ein kreisförmiger Krater in einer Bestrahlungszeit T entsteht. Der Durchmesser des Kraters wird an der Oberfläche vermessen und hat einen Durchmesser D und eine Tiefe H. Der Abstand zwischen zwei Lasereinschüssen wird als Abstand A bezeichnet.

Beim erfindungsgemäßen Verfahren kann der Abstand A bis Null gehen. Als Resultat hiervon entsteht eine Laserspur. Der einzelne Lasereinschuss hat die Form eines trichterförmigen Sackloches. Die Struktur einer mit sehr geringen Abständen Ader Lasereinschüsse voneinander eingebrachten Laserspur hat die Form einer Art Kerbe. Hierdurch erhält man entlang der Laserspur eine Kerbstruktur.

Durch einen Vereinzelungsschritt entstehen aus einer Laserspur zwei neue Seitenflächen. Seitenflächen sind im Folgenden als Teiloberflächen eines beliebigen Körpers zu sehen. Die Summe der Teiloberflächen ergibt die Oberfläche des Körpers. Bei porösen Stoffen wird lediglich die einhüllende Oberfläche betrachtet, ohne die innere Oberfläche, bei zum Beispiel einer Offenporigkeit.

Ein Bauteil kann ein beliebig geformter dreidimensionaler Körper oder auch ein flächiges Bauteil mit zwei nahezu planparallelen Oberflächen sein. Unter einem flächigen Bauteil wird eine Platte verstanden.

In einer erfindungsgemäßen Ausbildung ist die Tiefe H der Lasereinschüsse gleich. Hierdurch ist die Laserspur überall gleich tief und alle Stellen der Laserspur sind in Bezug auf die Bruchfähigkeit gleich.

In einer anderen erfindungsgemäßen Ausbildung ist die Tiefe H der Lasereinschüsse ungleich. Zum Beispiel kann die Laserspur an besonders kritischen Stellen tiefer sein als an anderen, so dass an diesen Stellen die Bruchfähigkeit verbessert ist. Da die Tiefe der Lasereinschüsse extrem wichtig für die Bruchfähigkeit ist, muss die Tiefe je nach den Erfordernissen gewählt werden.

Zur weiteren Verbesserung der Bruchfähigkeit kann die Laserspur in sich gegenüberliegenden Seitenflächen des Bauteils eingebracht sein. Es bleibt an diesen Stellen nach dem Lasern und vor dem Brechen nur ein im Inneren angeordneter Steg, in den die jeweiligen Lasereinschüsse beider Seitenflächen münden.

In einer anderen erfindungsgemäßen Ausführungsvariante weisen die Bauteile auf gegenüberliegenden Seitenflächen eine deckungsgleiche Laserspur auf. Hierdurch ist die Bruchfähigkeit auf beiden Seitenflächen gleich, d.h. das Bauteil kann beliebig geteilt werden.

In einer bevorzugten Ausführungsform besteht das Bauteil aus einer Keramik oder Glas, wie beispielsweise Halbleitermaterialien, Aluminiumoxide, Zirkonoxide oder Mischkeramiken. In bevorzugter Ausgestaltung werden Keramiken verwendet.

In einer vorteilhaften erfindungsgemäßen Ausbildung sind die Bauteile Keramikplatten, die als Substrate für elektronische oder elektrische Bauteile verwendet werden. Gerade bei den Substraten ist der Mehrfachnutzen enorm. Das Bauteil kann auch ein mit Feststoffen gefülltes und/oder ungefülltes Polymer sein. Das mit Feststoffen gefüllte Polymer ist bevorzugt eine ungesinterte keramische Folie. In einer weiteren Ausgestaltung enthält die Folie im Inneren eine ungesinterte Keramik, die von einem Polymer eingehüllt ist.

Das erfindungsgemäße Verfahren zur Herstellung dieses Bauteils ist in Anspruch 11 definiert.

In einer vorteilhaften Ausführungsform wird mindestens ein zweites Mal an derselben Stelle ein Lasereinschuss eingebracht. Hierdurch kann die Tiefe und/oder die Größe der Laserspur gezielt ausgeformt werden.

Nachfolgend wird die Erfindung anhand von 6 Figuren weiter erläutert.

Figur 1 zeigt einen Schnitt durch ein Bauteil 1 nach dem Stand der Technik entlang der Laserspur 2. Figur 2 zeigt eine Ansicht dieses Bauteil. Beide Figuren zeigen dasselbe Bauteile 1 mit einer Laserspur 2 als Bruchinitiierungslinie, die aus Lasereinschüssen 3 eines Laserstrahls besteht, zur Vorbereitung für eine spätere Vereinzelung des Bauteils 1 in hier nicht gezeigte Einzelbauteile. Das Bauteil 1 trägt nach dem Lasern und vor dem Vereinzeln die Laserspur 2 in sich. Nach dem Vereinzeln des Bauteils 1 sind zwei Einzelbauteile entstanden. Die Laserspur 2 wirkt als Bruchinitiierungslinie und erleichtert das Vereinzeln des Bauteils entlang der Laserspur 2. Die Laserspur 2 ist bevorzugt nach Außen sichtbar auf einer Seitenfläche eingebracht. Das Bauteil wird dann entlang der Laserspur 2 gebrochen. Die Laserspur wird dadurch eine Außenkante des Einzelbauteils. Es entstehen zwei neue Seitenflächen.

Die in den Figuren 1 und 2 gezeigten Bauteile bestehen aus einer Keramik und sind Substrate, welche nach dem Stand der Technik mit Lasereinschüssen 3 versehen wurden, die als Bruchinitiierungsstellen dienen. Wird dieses Bauteil 1 entlang der Laserspur 2 gebrochen und vereinzelt entstehen zwei Einzelbauteile. Die Bruchfläche 6 zeigt an dem Ort der Einschüsse Halbkreise 7, die jeweils von Stegen 8 eingerahmt sind.

Die Figur 3 zeigt ein Einzelbauteil 9 welches aus einem erfindungsgemäßen Bauteil 1 durch Brechen entlang der Laserspur 2 erzeugt wurde, d.h. zeigt ein Teil des Bauteils nach der Vereinzelung. In der hier gezeigten Ausführungsform grenzen die Lasereinschüsse 3 aneinander an, so dass der Abstand A zwischen zwei benachbarten Lasereinschüssen 3 kleiner oder gleich dem Durchmesser D dieser Lasereinschüsse 3, jeweils gemessen an der Oberfläche des Bauteils, ist. Die Bruchfläche ist mit dem Bezugszeichen 6 gekennzeichnet. Mit dem Bezugszeichen 11 ist eine Ausnehmung bezeichnet, die bei der Verwendung des Einzelbauteils erforderlich ist. Gezeigt wird gemäß der Erfindung, dass die Laserspur 2 auch mit beliebigen Ausnehmungen 11 kombiniert werden kann. In der hier gezeigten Ausführungsform sind gemäß der Erfindung Bereiche der Laserspur 2 ohne Lasereinschüsse 3.

Die Figuren sind schematisiert, so dass ihnen keine Maße entnommen werden können.

In Figur 2 sind der Abstand A und der Durchmesser D eingezeichnet, um diese zu erklären.

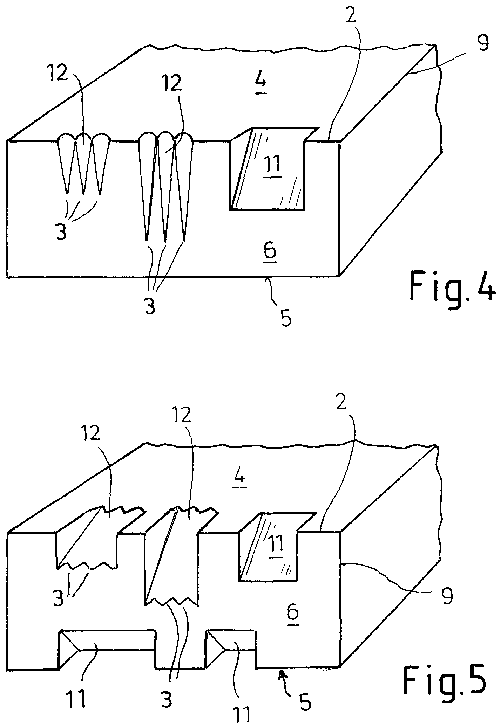

Die Figuren 4 und 5 zeigen Einzelbauteile 9, nach der Vereinzelung aus einem Bauteil 1, bei denen die Lasereinschüsse 3 jeweils zu zwei Gruppen 12 zusammengefasst sind. Außer diesen Gruppen 12 von Lasereinschüssen 3 sind Ausnehmungen 11 in der Bruchfläche 6 angeordnet. Die Lasereinschüsse 3 einer Gruppe 12 haben in dieser Ausführungsform alle die gleiche Tiefe, wobei die Lasereinschüsse 3 einer Gruppe 12 eine andere Tiefe aufweisen als die Lasereinschüsse der anderen Gruppe 12. In der Ausführungsform gemäß Figur 4 sind die Lasereinschüsse 3 von nur einer Seitenfläche 4 eingebracht. In der Ausführungsform gemäß Figur 5 sind alle Lasereinschüsse 3 auch nur von einer Seitenfläche 4 eingebracht, jedoch sind Ausnehmungen 11 auch von der gegenüberliegenden Seitenfläche 5 eingebracht worden.

Figuren 6a und 6b sind nicht Zeil der Erfindung.

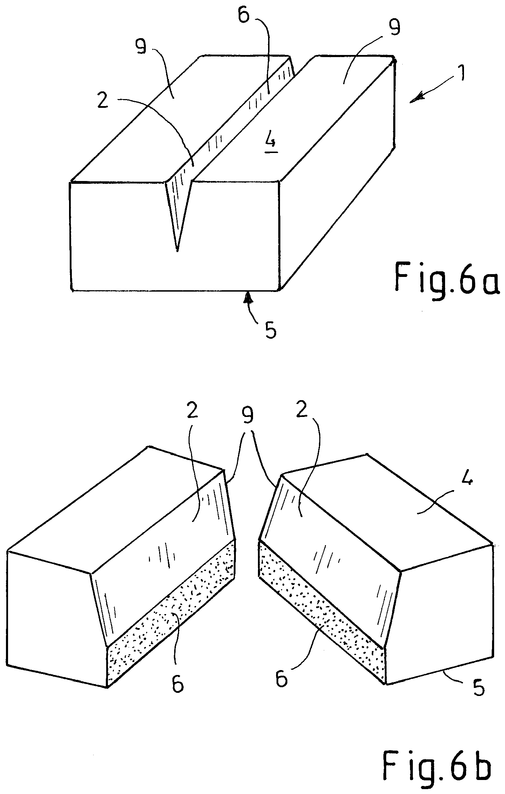

Figur 6a zeigt ein Bauteil 1 nach dem Einbringen der Laserspur 2 und vor dem Vereinzeln. Es ist eine kerbförmige Laserspur 2 entstanden. Figur 6b zeigt zwei aus dem Bauteil 1 von Figur 6a durch Vereinzeln entstandene Einzelbauteile 9. Mit 2 ist in beiden Figuren die Laserspur bezeichnet, bzw. die Hälfte der Laserspur (in Figur 6b). Die Bruchfläche 6 weist eine verminderte Materialstärke auf.

## Patentansprüche

1. Bauteil (1) mit einer Laserspur (2) als Bruchinitiierungslinie, die aus Lasereinschüssen (3) eines Laserstrahls besteht, zur Vorbereitung für eine spätere Vereinzelung des Bauteils (1) in Einzelbauteile, wobei der Abstand A zwischen zwei benachbarten Lasereinschüssen (3) kleiner oder gleich dem Durchmesser D dieser Lasereinschüsse (3) ist, jeweils gemessen an der Oberfläche des Bauteils (1), **dadurch gekennzeichnet, dass** die Laserspur (2) mit Ausnehmungen (11) kombiniert ist und Bereiche der Laserspur (2) ohne Lasereinschüsse (3) sind.

2. Bauteil nach Anspruch 1, **dadurch gekennzeichnet, dass** die Tiefe H der Lasereinschüsse (3) gleich ist.

3. Bauteil nach Anspruch 1, **dadurch gekennzeichnet, dass** die Tiefe H der Lasereinschüsse (3) ungleich ist.

4. Bauteil nach einem der Ansprüche 1 bis 3, **dadurch gekennzeichnet, dass** die Laserspur (2) in sich gegenüberliegenden Seitenflächen (4, 5) des Bauteils (1) eingebracht ist.

5. Bauteil nach einem der Ansprüche 1 bis 4, **dadurch gekennzeichnet, dass** die Bauteile (1) auf gegenüberliegenden Seitenflächen (4, 5) eine deckungsgleiche Laserspur (2) aufweisen.

6. Bauteil nach einem der Ansprüche 1 bis 5, **dadurch gekennzeichnet, dass** das Bauteil (1) aus einer Keramik oder Glas, wie beispielsweise Halbleitermaterialien, Aluminiumoxide, Zirkonoxide oder Mischkeramiken besteht.

7. Bauteil nach einem der Ansprüche 1 bis 6, **dadurch gekennzeichnet, dass** die Bauteile (1) Keramikplatten sind, die als Substrate für elektronische oder elektrische Bauteile verwendet werden.

8. Bauteil nach einem der Ansprüche 1 bis 7, **dadurch gekennzeichnet, dass** das Bauteil (1) ein mit Feststoffen gefülltes und/oder ungefülltes Polymer ist.

9. Bauteil nach Anspruch 8, **dadurch gekennzeichnet, dass** das mit Feststoffen gefüllte Polymer eine ungesinterte keramische Folie ist.

10. Bauteil nach Anspruch 8, **dadurch gekennzeichnet, dass** die Folie im Inneren eine ungesinterte Keramik enthält, die von einem Polymer eingehüllt ist.

11. Verfahren zur Herstellung eines Bauteils nach einem der Ansprüche 1 bis 10, **dadurch gekennzeichnet, dass** während der Bestrahlungszeit des Bauteils (1) der Laserstrahl und/oder das Bauteil bewegt werden, um die Laserspur (2) einzubringen.

12. Verfahren nach Anspruch 11, **dadurch gekennzeichnet, dass** mindestens ein zweites Mal an derselben Stelle ein Lasereinschuss (3) eingebracht wird.

## Claims

1. A component (1) having a laser track (2) as a break-initiation line that consists of laser holes (3) of a laser beam, for preparation for subsequent separation of the component (1) into individual components, wherein the distance A between two adjacent laser holes (3) is smaller than or equal to the diameter D of these laser holes (3), in each case measured at the surface of the component (1), **characterised in that** the laser track (2) is combined with recesses (11), and regions of the laser track (2) are without laser holes (3).

2. A component according to claim 1, **characterised in that** the depth H of the laser holes (3) is equal.

3. A component according to claim 1, **characterised in that** the depth H of the laser holes (3) is unequal.

4. A component according to one of claims 1 to 3, **characterised in that** the laser track (2) is introduced into opposing side faces (4, 5) of the component (1).

5. A component according to one of claims 1 to 4, **characterised in that** the components (1) have a congruent laser track (2) on opposing side faces (4, 5).

6. A component according to one of claims 1 to 5, **characterised in that** the component (1) consists of a ceramic material or glass, such as, for example, semiconductor materials, aluminium oxides, zirconium oxides or mixed ceramic materials.

7. A component according to one of claims 1 to 6, **characterised in that** the components (1) are ceramic plates that are used as substrates for electronic or electrical components.

8. A component according to one of claims 1 to 7, **characterised in that** the component (1) is a polymer that is filled with solids and/or is unfilled.

9. A component according to claim 8, **characterised in that** the polymer that is filled with solids is an unsintered ceramic film.

10. A component according to claim 8, **characterised in that** the film internally contains an unsintered ceramic material that is encased by a polymer.

11. A method for producing a component according to one of claims 1 to 10, **characterised in that** during the time of irradiation of the component (1) the laser beam and/or the component are moved in order to introduce the laser track (2).

12. A method according to claim 11, **characterised in that** a laser hole (3) is introduced at least a second time at the same point.

## Revendications

1. Composant (1) comportant un sillon laser (2) en tant que ligne d'amorce de rupture, qui est constitué d'injections laser (3) d'un faisceau laser, en vue de la préparation d'une séparation ultérieure du composant (1) en composants individuels, la distance A entre deux injections laser (3) voisines étant inférieure ou égale au diamètre D de ces injections laser (3), mesuré respectivement à la surface du composant (1), **caractérisé en ce que** le sillon laser (2) est combiné avec des évidements (11) et que des zones du sillon laser (2) sont exemptes d'injections laser (3).

2. Composant selon la revendication 1, **caractérisé en ce que** la profondeur H des injections laser (3) est identique.

3. Composant selon la revendication 1, **caractérisé en ce que** la profondeur H des injections laser (3) n'est pas identique.

4. Composant selon l'une des revendications 1 à 3, **caractérisé en ce que** le sillon laser (2) est réalisé dans des faces (4, 5) opposées du composant (1).

5. Composant selon l'une des revendications 1 à 4, **caractérisé en ce que** les composants (1) présentent, sur des faces (4, 5) opposées, des sillons laser (2) qui coïncident.

6. Composant selon l'une des revendications 1 à 5, **caractérisé en ce que** le composant (1) est constitué d'une céramique ou de verre, par exemple de matériaux semi-conducteurs, d'oxydes d'aluminium, d'oxydes de zirconium ou de céramiques mixtes.

7. Composant selon l'une des revendications 1 à 6, **caractérisé en ce que** les composants (1) sont des plaques en céramique qui sont utilisées en tant que substrats pour des composants électroniques ou électriques.

8. Composant selon l'une des revendications 1 à 7, **caractérisé en ce que** le composant (1) est un polymère chargé en matières solides et/ou un polymère non chargé.

9. Composant selon la revendication 8, **caractérisé en ce que** le polymère chargé en matières solides est une feuille de céramique non frittée.

10. Composant selon la revendication 8, **caractérisé en ce que** la feuille contient à l'intérieur une céramique non frittée qui est enveloppée d'un polymère.

11. Procédé de fabrication d'un composant selon l'une des revendications 1 à 10, **caractérisé en ce que**, pendant le temps d'irradiation du composant (1), le faisceau laser et/ou le composant sont déplacés pour réaliser le sillon laser (2).

12. Procédé selon la revendication 11, **caractérisé en ce qu'**une injection laser (3) est réalisée au moins une deuxième fois au même endroit.
